# EUROPEAN PATENT SPECIFICATION

(11) **EP 4 379 798 B1**
(45) Date of publication and mention of the grant of the patent: **27.08.2025**
(21) Application number: 23192380.6
(22) Date of filing: 21.08.2023
(51) Int. Cl.: H01L 23/538, H01L 21/56, H01L 23/498

(54) **SEMICONDUCTOR PACKAGE AND METHOD OF FABRICATING THE SAME**
HALBLEITERGEHÄUSE UND VERFAHREN ZU DESSEN HERSTELLUNG
BOÎTIER DE SEMI-CONDUCTEUR ET SON PROCÉDÉ DE FABRICATION

(30) Priority: 30.11.2022 KR 20220165054; 06.01.2023 KR 20230002262
(43) Date of publication of application: 05.06.2024
(73) Proprietor: Samsung Electronics Co., Ltd., Suwon-si, Gyeonggi-do 16677 (KR)
(72) Inventor: KANG, Myung-Sung, Suwon-si, Gyeonggi-do 16677 (KR); KOH, Kyong Hwan, Suwon-si, Gyeonggi-do 16677 (KR); PARK, Jin-Woo, Suwon-si, Gyeonggi-do 16677 (KR); LEE, Chung Sun, Suwon-si, Gyeonggi-do 16677 (KR); JIN, Hyeon Jun, Suwon-si, Gyeonggi-do 16677 (KR)
(74) Representative: Kuhnen & Wacker Patent- und Rechtsanwaltsbüro PartG mbB

(56) References cited:
- WO-A2-2016/123607
- US-A1- 2013 175 699
- US-A1- 2014 008 795
- US-A1- 2014 038 354

## Description

### BACKGROUND

### 1. Technical Field

The present disclosure relates to semiconductor packages and/or methods of fabricating the same.

### 2. Description of the Related Art

Semiconductor packages are being developed to efficiently fabricate semiconductor chips having more diverse functions and high reliability. In addition, in order to mount more semiconductor chips in the same area, a stacked semiconductor package in which a plurality of semiconductor chips are stacked has been proposed. For example, a package-in-package (PIP) type semiconductor package or a package-on-package (POP) type semiconductor package may be used.

On the other hand, when many semiconductor chips are mounted in one semiconductor package in this way, defects such as void traps may occur during a molding process of the semiconductor package.

Accordingly, research into a technology capable of preventing unfilled molding members and occurrence of void trap defects during a molding process for the semiconductor package in which many semiconductor chips are mounted is being conducted.

WO 2016/123607 A2 discloses an apparatus relating generally to a microelectronic assembly. In such an apparatus, a contact arrangements are disposed on a first surface of a first substrate, including first contacts disposed as a first ring array; second contacts disposed interior to the first contacts as a second ring array; third contacts disposed interior to the second contacts as a third ring array; and fourth contacts disposed interior to the third contacts on the first surface as an innermost array. The first ring array, the second ring array, and the third ring array are concentric rings with the innermost array in a central region of the concentric rings. The first contacts and the fourth contacts are for interconnection with first microelectronic dies. The second contacts and the third contacts are for interconnection with second microelectronic dies.

US 2013/175699 A1 discloses a microelectronic assembly including a first microelectronic package having a substrate with first and second opposed surfaces and substrate contacts thereon. The first package further includes first and second microelectronic elements, each having element contacts electrically connected with the substrate contacts and being spaced apart from one another on the first surface so as to provide an interconnect area of the first surface between the first and second microelectronic elements. A plurality of package terminals at the second surface are electrically interconnected with the substrate contacts for connecting the package with a component external thereto. A plurality of stack terminals are exposed at the first surface in the interconnect area for connecting the package with a component overlying the first surface of the substrate. The assembly further includes a second microelectronic package overlying the first microelectronic package and having terminals joined to the stack terminals of the first microelectronic package.

### SUMMARY

The invention is defined in the appended independent claims. Further developments of the invention are specified in the dependent claims.

Some example embodiments of the present disclosure provide semiconductor packages with improved product reliability.

Some example embodiments of the present disclosure also provide methods of fabricating a semiconductor package with improved product reliability.

However, example embodiments of the present disclosure are not restricted to those set forth herein. The above and other aspects of the present disclosure will become more apparent to one of ordinary skill in the art to which the present disclosure pertains by referencing the detailed description of the present disclosure given below.

According to an example embodiment of the present disclosure, a semiconductor package includes a first package substrate including a first area, a first semiconductor chip on the first area, a second package substrate on an upper surface of the first semiconductor chip, the second package substrate including a second area and a first hole penetrating through the second area, a second semiconductor chip on the second area, a connection member electrically connecting the first package substrate and the second package substrate, a connection member being between the first package substrate and the second package substrate, and a mold film covering the second semiconductor chip on the second package substrate, filling the first hole, and covering the first semiconductor chip and the connection member on the first package substrate.

According to an example embodiment of the present disclosure, a semiconductor package includes a first package substrate, an upper pad exposed from an upper surface of the first package substrate, a first semiconductor chip on the upper surface of the first package substrate, a second package substrate on an upper surface of the first semiconductor chip and spaced apart from the upper surface of the first semiconductor chip, a lower pad exposed from a lower surface of the second package substrate, a second semiconductor chip on an upper surface of the second package substrate, a connection member electrically connecting the first package substrate and the second package substrate, the connection member being in direct contact with the upper pad and the lower pad, and a mold film covering the first semiconductor chip and the connection member on the first package substrate and covering the second semiconductor chip on the second package substrate, wherein the first package substrate includes a first hole penetrating through the first package substrate in a first direction, the second package substrate includes a second hole penetrating through the second package substrate in the first direction, the first hole overlaps the first semiconductor chip in plan view, and the second hole overlaps the second semiconductor chip in plan view.

According to an example embodiment of the present disclosure, a method of fabricating a semiconductor package includes forming a first hole penetrating through a first package substrate in a first direction, mounting a first semiconductor chip on an upper surface of the first package substrate so as to overlap the first hole in plan view, forming a connection member on the upper surface of the first package substrate, forming a second hole penetrating through a second package substrate in the first direction, disposing the second package substrate on an upper surface of the first semiconductor chip so that an upper end of the connection member is in direct contact with a lower pad exposed from a lower surface of the second package substrate, mounting a second semiconductor chip on an upper surface of the second package substrate so as to overlap the second hole in plan view, and forming a mold film covering the first semiconductor chip and the connection member on the first package substrate and covering the second semiconductor chip on the second package substrate.

It should be noted that the effects of the present disclosure are not limited to those described above, and other effects of the present disclosure will be apparent from the following description.

### BRIEF DESCRIPTION OF THE DRAWINGS

The above and other aspects and features of the present disclosure will become more apparent by describing in detail some example embodiments thereof with reference to the attached drawings, in which:
FIG. 1 is an illustrative plan view for describing a semiconductor package according to an example embodiment.
FIG. 2 is an illustrative cross-sectional view for describing a semiconductor package according to an example embodiment.
FIG. 3 is an enlarged view for describing area B of FIG. 2.
FIG. 4 is an illustrative plan view for describing a semiconductor package according to an example embodiment.
FIG. 5 is an illustrative cross-sectional view for describing a semiconductor package according to some exemplary embodiments.
FIG. 6 is an illustrative view for describing an effect of the semiconductor package according to an example embodiment.
FIGS. 7 to 19 are various illustrative views for describing a semiconductor package according to some example embodiments.
FIG. 20 is an illustrative flowchart illustrating a method of fabricating a semiconductor package according to an example embodiment.
FIGS. 21 to 27 are intermediate step drawings for describing the method of fabricating the semiconductor package according to an example embodiment.

### DETAILED DESCRIPTION

Hereinafter, semiconductor packages and/or methods of fabricating the same according to some example embodiments will be described with reference to the accompanying drawings.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

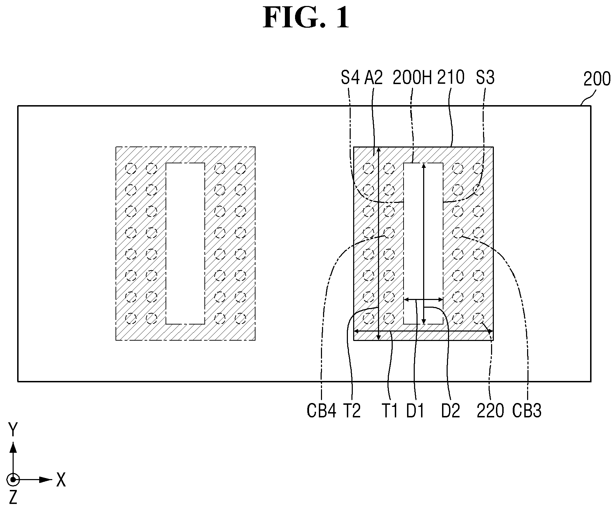

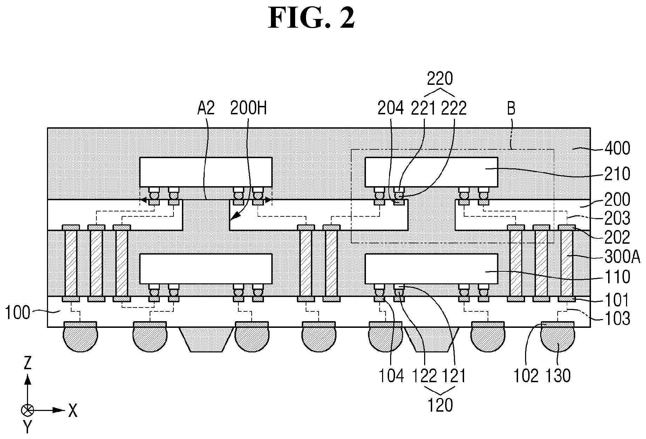

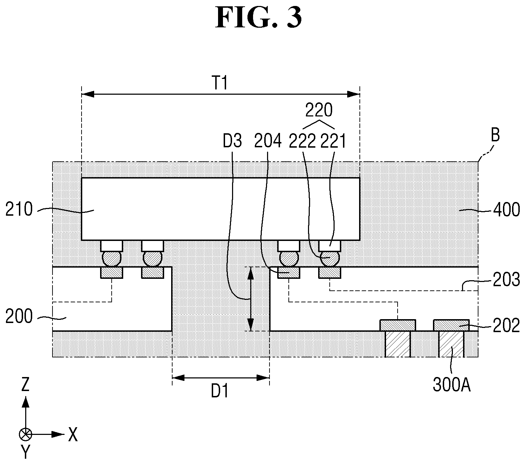

FIG. 1 is an illustrative plan view for describing a semiconductor package according to an example embodiment. FIG. 2 is an illustrative cross-sectional view for describing a semiconductor package according to an example embodiment. FIG. 3 is an enlarged view for describing area B of FIG. 2. Hereinafter, a semiconductor package according to some example embodiments will be described with reference to FIGS. 1 to 3.

First, referring to FIGS. 1 and 2 together, a semiconductor package according to some example embodiments may include a first package substrate 100, a first semiconductor chip 110, a second package substrate 200, a second semiconductor chip 210, a connection member 300A, and a mold film 400.

The first package substrate 100 may be a substrate for a package. For example, the first package substrate 100 may be a printed circuit board (PCB) or a ceramic substrate. In some example embodiments, the first package substrate 100 may also be a substrate for a wafer level package (WLP) manufactured at a wafer level. The first package substrate 100 may have a single layer or multiple layers. The first package substrate 100 may include a lower surface and an upper surface that are opposite to each other in a first direction Z. In the following description, lower and upper surfaces of components (e.g., the first package substrate 100 and the first semiconductor chip 110) included in the semiconductor package may be based on the first direction Z.

The first package substrate 100 may include a first lower pad 102, an upper pad 101, a first chip pad 104, and a first wiring pattern 103. The first lower pad 102 may be exposed from the lower surface of the first package substrate 100. Each of the upper pad 101 and the first chip pad 104 may be exposed from the upper surface of the first package substrate 100. Each of the first lower pad 102, the upper pad 101, and the first chip pad 104 may include, at least one of, for example, aluminum (Al), copper (Cu), nickel (Ni), tungsten (W), platinum (Pt), gold (Au), and a combination thereof, but is not limited thereto.

Each of the first lower pad 102, the upper pad 101, and the first chip pad 104 may be connected to the first wiring pattern 103, which is an electrical circuit formed in the first package substrate 100. That is, each of the first lower pad 102, the upper pad 101, and the first chip pad 104 is a portion (pattern or pad) to which the first wiring pattern 103 of the first package substrate 100 is connected to the outside.

In some example embodiments, a connection terminal 130 may be formed on the lower surface of the first package substrate 100. The connection terminal 130 may be used to electrically connect the first package substrate 100 and an external device. For example, the connection terminal 130 may be in contact with the first lower pad 102 of the first package substrate 100. Accordingly, the connection terminal 130 may provide an electrical signal from the external device to the first package substrate 100 or may provide an electrical signal from the first package substrate 100 to an external device.

The connection terminal 130 may be, for example, a spherical, hemispherical, or elliptical bump, a solder ball, or under bump metallurgy (UBM), but is not limited thereto. The connection terminal 130 may include, for example, tin (Sn), indium (In), bismuth (Bi), antimony (Sb), copper (Cu), silver (Ag), zinc (Zn), lead (Pb), or a combination thereof, but is not limited thereto.

The first semiconductor chip 110 may be mounted on the first package substrate 100. As an example, the first semiconductor chip 110 may be mounted on the upper surface of the first package substrate 100. It is illustrated in FIG. 2 that only two first semiconductor chips 110 are mounted on the upper surface of the first package substrate 100 and horizontally arranged on the upper surface of the first package substrate 100 in a second direction X, but the exemplary embodiments are not limited thereto. For example, in some example embodiments, only one first semiconductor chip 110 may be mounted on the upper surface of the first package substrate 100. In some other example embodiments, three or more first semiconductor chips 110 may be disposed on the first package substrate 100 and/or horizontally arranged in the second direction X and/or the third direction Y. In addition, in some example embodiments, two or more first semiconductor chips 110 may also be sequentially stacked on the first package substrate 100.

The first semiconductor chip 110 may be an integrated circuit (IC) in which hundreds to millions of semiconductor elements are integrated into a single chip. For example, the first semiconductor chip 110 may be memory chips such as volatile memory (e.g., DRAM) or non-volatile memory (e.g., ROM or flash memory), application Processor (AP) chips such as Central Processing Unit (CPU), Graphic Processing Unit (GPU), Field-Programmable Gate Array (FPGA), digital signal processor, encryption processor, microprocessor, or microcontroller, and logic chips such as analog-digital converters (ADCs) or application-specific ICs (ASICs), but is not limited thereto. In addition, the first semiconductor chip 110 may also be configured by combining the above-mentioned elements.

In some example embodiments, a first chip bump group 120 may be formed between the first package substrate 100 and the first semiconductor chip 110. For example, the first chip bump group 120 may be formed between the upper surface of the first package substrate 100 and the lower surface of the first semiconductor chip 110. The first chip bump group 120 may include a plurality of bumps. The first chip bump group 120 may electrically connect the first package substrate 100 and the first semiconductor chip 110. For example, the first semiconductor chip 110 may be mounted on the first package substrate 100 by a flip chip bonding method.

For example, each of the plurality of bumps included in the first chip bump group 120 may include a first pillar layer 121 and a first solder layer 122. The first pillar layer 121 may be a post-shaped structure protruding from the lower surface of the first semiconductor chip 110. In addition, the first pillar layer 121 may be electrically connected to the first semiconductor chip 110. The first pillar layer 121 may include, for example, copper (Cu), a copper alloy, nickel (Ni), a nickel alloy, palladium (Pd), platinum (Pt), gold (Au), cobalt (Co), or a combination thereof, but is not limited thereto.

The first solder layer 122 may electrically connect the first pillar layer 121 and the first package substrate 100 to each other. For example, the first solder layer 122 may be in contact with the first chip pad 104 of the first package substrate 100. The first solder layer 122 may have, for example, a spherical, hemispherical, or ellipsoidal structure. The first solder layer 122 may include, for example, tin (Sn), indium (In), bismuth (Bi), antimony (Sb), copper (Cu), silver (Ag), zinc (Zn), lead (Pb), or a combination thereof, but is not limited thereto.

The second package substrate 200 may be disposed on the upper surface of the first semiconductor chip 110. The second package substrate 200 may include a lower surface and an upper surface that are opposite to each other in a first direction Z. The upper surface of the first semiconductor chip 110 and the lower surface of the second package substrate 200 may be spaced apart from each other in the first direction Z perpendicular to the upper surface of the first semiconductor chip 110. The second package substrate 200 may be a substrate for a package. For example, the second package substrate 200 may be a printed circuit board (PCB) or a ceramic substrate. In some example embodiments, the second package substrate 200 may be a substrate for a wafer level package (WLP) manufactured at a wafer level. The second package substrate 200 may have a single layer or multiple layers. In some other example embodiments, the second package substrate 200 may be an interposer.

The second package substrate 200 may include a second lower pad 202, a second chip pad 204, and a second wiring pattern 203. The second lower pad 202 may be exposed from the lower surface of the second package substrate 200. The second chip pad 204 may be exposed from the upper surface of the second package substrate 200. Each of the second lower pad 202 and the second chip pad 204 may include, at least one of, for example, aluminum (Al), copper (Cu), nickel (Ni), tungsten (W), platinum (Pt), gold (Au), or a combination thereof, but is not limited thereto.

Each of the second lower pad 202 and the second chip pad 204 may be connected to the second wiring pattern 203, which is an electrical circuit formed in the second package substrate 200. That is, each of the second lower pad 202 and the second chip pad 204 is a portion (pattern or pad) to which the second wiring pattern 203 of the second package substrate 200 is connected to the outside.

The second semiconductor chip 210 may be mounted on the second package substrate 200. As an example, the second semiconductor chip 210 may be mounted on the upper surface of the second package substrate 200. For example, the second semiconductor chip 210 may be mounted on a second area A2 of the upper surface of the second package substrate 200. The second area A2 may be an area of the upper surface of the second package substrate 200 overlapping the second semiconductor chip 210 in a vertical view (e.g., in the first direction Z perpendicular to the upper surface of the second package substrate 200).

It is illustrated in FIGS. 1 and 2 that only two second semiconductor chips 210 are mounted on the upper surface of the second package substrate 200 and horizontally arranged in the second direction X, but example embodiments are not limited thereto. For example, in some example embodiments, only one second semiconductor chip 210 may be mounted on the upper surface of the second package substrate 200. In some other example embodiments, three or more second semiconductor chips 210 may be disposed on the second package substrate 200 and horizontally arranged in the second direction X and/or the third direction Y. In addition, in some example embodiments, two or more second semiconductor chips 210 may be sequentially stacked on the second package substrate 200.

The second semiconductor chip 210 may be an integrated circuit (IC) in which hundreds to millions of semiconductor elements are integrated into a single chip. For example, the second semiconductor chip 210 may be memory chips such as volatile memory (e.g., DRAM) or non-volatile memory (e.g., ROM or flash memory), application Processor (AP) chips such as Central Processing Unit (CPU), Graphic Processing Unit (GPU), Field-Programmable Gate Array (FPGA), digital signal processor, encryption processor, microprocessor, or microcontroller, and logic chips such as analog-digital converters (ADCs) or application-specific ICs (ASICs), but is not limited thereto. In addition, the second semiconductor chip 210 may also be configured by combining the above-mentioned elements. In some example embodiments, both the first semiconductor chip 110 and the second semiconductor chip 210 may be volatile memories (e.g., DRAM).

In some example embodiments, as illustrated in FIGS. 1 and 2, a second hole 200H penetrating through the second package substrate 200 in the first direction Z may be formed in the second package substrate 200. For example, referring to FIG. 3, a length (e.g., depth) D3 of the second hole 200H in the first direction Z may be the same as a length (e.g., depth) of the second package substrate 200 in the first direction Z. The second hole 200H may be formed to penetrate through the second area A2 on the second package substrate 200. For example, the second hole 200H may be formed to penetrate through a portion of an area A2 on the upper surface of the second package substrate overlapping the second semiconductor chip 210 in the vertical view. For example, the second hole 200H may be provided at a center or central part of an area A2 on the upper surface of the second package substrate overlapping the second semiconductor chip 210 in the vertical view. The second hole 200H may have a rectangular shape in plan view as illustrated in FIG. 1, but example embodiment is not limited thereto. The second hole 200H may have a shape extending to be long (e.g., elongating) along the third direction Y and being parallel to the lower surface of the second semiconductor chip 210.

Referring to FIGS. 1 and 3 together, a length D1 of the second hole 200H in the second direction X may be shorter than a length T1 of the second semiconductor chip 210 in the second direction X. In addition, a length D2 of the second hole 200H in the third direction Y may be shorter than a length T2 of the second semiconductor chip 210 in the third direction Y.

In some example embodiments, a second chip bump group 220 may be formed between the second package substrate 200 and the second semiconductor chip 210. For example, the second chip bump group 220 may be formed between the upper surface of the second package substrate 200 and the lower surface of the second semiconductor chip 210. The second chip bump group 220 may include a plurality of bumps. The second chip bump group 220 may electrically connect the second package substrate 200 and the second semiconductor chip 210. For example, the second semiconductor chip 210 may be mounted on the second package substrate 200 by a flip chip bonding method.

For example, each of the plurality of bumps included in the second chip bump group 220 may include a second pillar layer 221 and a second solder layer 222. The second pillar layer 221 may be a post-shaped structure protruding from the lower surface of the second semiconductor chip 210. In addition, the second pillar layer 221 may be electrically connected to the second semiconductor chip 210. The second pillar layer 221 may include, for example, copper (Cu), a copper alloy, nickel (Ni), a nickel alloy, palladium (Pd), platinum (Pt), gold (Au), cobalt (Co), or a combination thereof, but is not limited thereto.

The second solder layer 222 may electrically connect the second pillar layer 221 and the second package substrate 200 to each other. For example, the second solder layer 222 may be in contact with the second chip pad 204 of the second package substrate 200. The second solder layer 222 may have, for example, a spherical, hemispherical, or ellipsoidal structure. The second solder layer 222 may include, for example, tin (Sn), indium (In), bismuth (Bi), antimony (Sb), copper (Cu), silver (Ag), zinc (Zn), lead (Pb), or a combination thereof, but is not limited thereto.

Referring back to FIG. 1, the second chip bump group 220 may include third chip bumps CB3 disposed on one side S3 of the second hole 200H and fourth chip bumps CB4 disposed on another side S4 of the second hole 200H. The number of third chip bumps CB3 and fourth chip bumps CB4 is plural, respectively, and the plurality of third chip bumps CB3 and the plurality of fourth chip bumps CB4 may be disposed along the third direction Y with the second hole 200H interposed therebetween. As such, the second hole 200H may be disposed between the third chip bumps CB3 and the fourth chip bumps CB4 in the second area A2.

A connection member 300A may be formed between the first package substrate 100 and the second package substrate 200. The connection member 300A may electrically connect the first package substrate 100 and the second package substrate 200 to each other. For example, a lower end of the connection member 300A may be in direct contact with the upper pad 101 of the first package substrate 100, and an upper end of the connection member 300A may be in direct contact with the second lower pad 202 of the second package substrate 200. As described above, the semiconductor package according to some example embodiments may have a structure in which the second package substrate 200 is directly stacked on the first package substrate 100 through the connection member 300A.

The connection member 300A may have, for example, a cylindrical post shape, but is not limited thereto. The connection member 300A may include, for example, tin (Sn), indium (In), bismuth (Bi), antimony (Sb), copper (Cu), silver (Ag), zinc (Zn), lead (Pb), or a combination thereof, but is not limited thereto. The connection member 300A may be disposed at a side of the first semiconductor chip 110. For example, a plurality of connection members 300A may be disposed to surround the first semiconductor chip 110 in plan view.

A mold film 400 may be disposed on the upper surface of the first package substrate 100 and the upper surface of the second package substrate 200. The mold film 400 may cover the first package substrate 100, the first semiconductor chip 110, and the connection member 300A, and may cover the second package substrate 200 and the second semiconductor chip 210. For example, the connection member 300A may penetrate through the mold film 400 and connect the first package substrate 100 and the second package substrate 200 to each other. The mold film 400 may fill a space between the lower surface of the first semiconductor chip 110 and the upper surface of the first package substrate 100 and may cover the first chip bump group 120. The mold film 400 may fill a space between the lower surface of the second semiconductor chip 210 and the upper surface of the second package substrate 200 and may cover the second chip bump group 220. In addition, the mold film 400 may be formed to fill the second hole 200H.

As described above, in the semiconductor package in which the first semiconductor chip 110 on the first package substrate 100 and the second semiconductor chip 210 on the second package substrate 200 are vertically stacked as illustrated in FIG. 2, the mold film 400 formed on the first package substrate 100 and the mold film 400 formed on the second package substrate 200 may be integrally formed. In addition, the integrally formed mold film 400 may fill the second hole penetrating through the second package substrate 200. As described above, the mold film 400 formed on the upper surface of the first package substrate 100 and the mold film 400 formed on the upper surface of the second package substrate 200 may be integrally formed through hole 200H penetrating through the second package substrate 200.

The mold film 400 may include, for example, an insulating polymer material such as an epoxy molding compound (EMC), but is not limited thereto. The mold film 400 may include a thermosetting resin such as an epoxy resin, a thermoplastic resin such as a polyimide resin, or a resin having a reinforcing material such as filler included in the thermosetting resin and the thermoplastic resin, for example, Ajinomoto Build-up Film (ABF), FR-4, Bismaleimide Triazine (BT) resin, etc.

As the filler, one or more materials selected from the group consisting of silica (SiO₂), alumina (Al₂O₃), silicon carbide (SiC), barium sulfate (BaSO₄), talc, clay, mica powders, aluminum hydroxide (Al(OH)₃), magnesium hydroxide (Mg(OH)₂), calcium carbonate (CaCO₃), magnesium carbonate (MgCO₃), magnesium oxide (MgO), boron nitride (BN), aluminum borate (AlBO₃), barium titanate (BaTiO₃), and calcium zirconate (CaZrO₃) may be used. However, the material of the filler is not limited thereto, and may also include a metal material and/or an organic material.

In the semiconductor package illustrated in FIG. 2, it is illustrated that only the first semiconductor chip 110 on the first package substrate 100 and the second semiconductor chip 210 on the second package substrate 200 are vertically stacked, but the example embodiment is not limited thereto. For example, in some example embodiments, another package substrate and semiconductor chip may be stacked on the upper surface of the second semiconductor chip 210. That is, assuming that one package substrate and a semiconductor chip on the one package substrate are a single-stage semiconductor package, the semiconductor package according to some example embodiments may be implemented in a structure in which three or more stages of semiconductor packages are stacked.

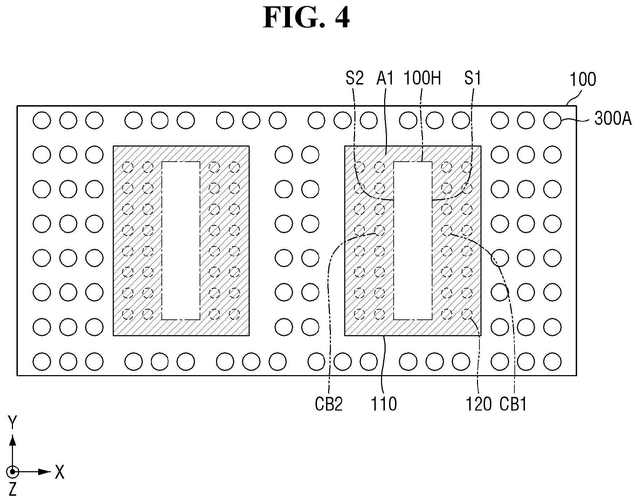

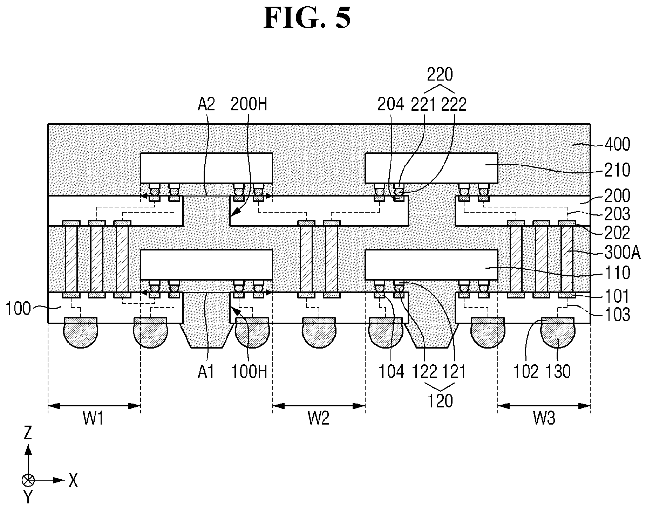

FIG. 4 is an illustrative plan view for describing a semiconductor package according to an example embodiment. FIG. 5 is an illustrative cross-sectional view for describing a semiconductor package according to an example embodiment. Hereinafter, overlapping descriptions with the foregoing will be omitted and differences will be mainly described.

Referring to FIGS. 4 and 5 together, in a semiconductor package according to some example embodiments, a first hole 100H penetrating through the first package substrate 100 in the first direction Z may be further formed, unlike that illustrated in FIG. 2. For example, a length of the first hole 100H in the first direction Z may be the same as a length of the first package substrate 100 in the first direction Z. The first hole 100H may be formed to penetrate through a first area A1 on the first package substrate 100. For example, the first hole 100H may be formed to penetrate through a portion of the first area A1, which is an area on the upper surface of the first package substrate 100 that overlaps the first semiconductor chip 110 in the vertical view. The first hole 100H may have a quadrangular shape extending to be long (e.g., elongating) along the third direction Y and being parallel to the lower surface of the first semiconductor chip 110 as illustrated in FIG. 4, but is not limited thereto.

A length of the first hole 100H in the second direction X may be shorter than a length of the first semiconductor chip 110 in the second direction X. In addition, a length of the first hole 100H in the third direction Y may be shorter than a length of the first semiconductor chip 110 in the third direction Y.

The first chip bump group 120 may include first chip bumps CB1 disposed on one side S1 of the first hole 100H and second chip bumps CB2 disposed on another side S2 of the first hole 100H. The number of first chip bumps CB1 and second chip bumps CB2 is plural, respectively, and the plurality of first chip bumps CB1 and the plurality of second chip bumps CB2 may be disposed along the third direction Y with the first hole 100H interposed therebetween. As such, the first hole 100H may be disposed between the first chip bumps CB1 and the second chip bumps CB2 in the first area A1.

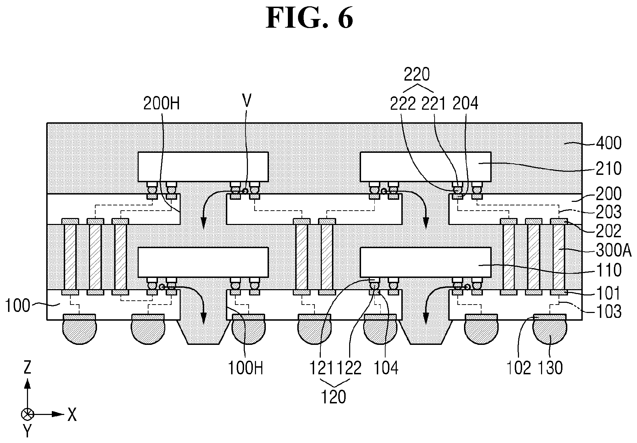

FIG. 6 is an illustrative view for describing an effect of the semiconductor package according to an example embodiment.

Referring to FIG. 6, the semiconductor package according to an example embodiment may mitigate or prevent voids from being trapped inside the mold films 400 formed between the lower surface of the first semiconductor chip 110 and the upper surface of the first package substrate 100 and between the lower surface of the second semiconductor chip 210 and the upper surface of the second package substrate 200 when the mold films 400 are formed, by providing the first hole 100H and the second hole 200H in the first package substrate 100 and the second package substrate 200, respectively. For example, in an encapsulation process in which the mold film 400 is formed, voids formed between the lower surface of the second semiconductor chip 210 and the upper surface of the second package substrate 200 may be easily discharged through the second hole 200H. In addition, in the first semiconductor chip 110 and the first package substrate 100 disposed on a lower side of the second package substrate 200, voids formed between the lower surface of the first semiconductor chip 110 and the upper surface of the first package substrate 100 may be easily discharged through the first hole 100H. Through this, a semiconductor package with improved product reliability may be provided.

In addition, by making a molding material constituting the mold film 400 flow on the upper surfaces of the first semiconductor chip 110 and the first package substrate 100 through the second hole 200H formed in the second package substrate 200, the encapsulation process of forming the mold film 400 in a semiconductor package in which a plurality of package substrates and a plurality of semiconductor chips are vertically stacked may be performed at once (in one step).

In addition, by directly connecting the package substrates 100 and 200 through the connection member 300A in the semiconductor package in which the plurality of package substrates and the plurality of semiconductor chips are vertically stacked, heat dissipation characteristics and electrical characteristics (e.g., power consumption characteristics or electrical connection speed characteristics) of the semiconductor package may be improved.

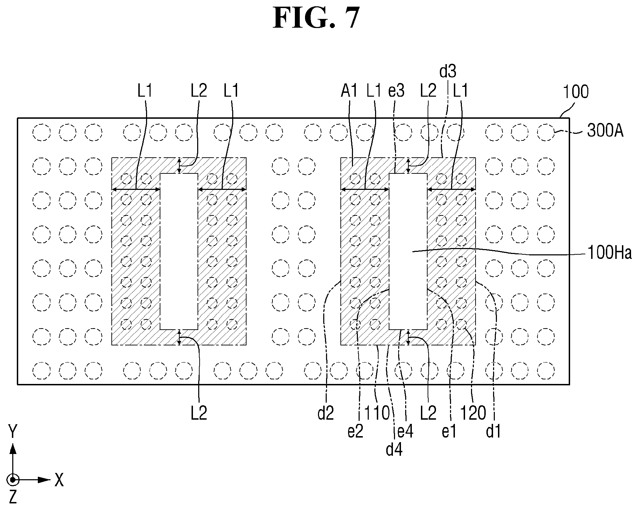

FIGS. 7 to 19 are various illustrative views for describing a semiconductor package according to some example embodiments.

Referring to FIG. 7, in a semiconductor package according to an example embodiment, a first hole 100Ha may be formed in a center or a central part of the first area A1 on the first package substrate 100. For example, as illustrated in FIG. 7, when the first hole 100Ha and the first area A1 each have a rectangular shape, a distance L1 from a first side d1 of the first area A1 to a first side e1 of the first hole 100Ha may be the same as a distance L1 from a second side d2 of the first area A1 to a second side e2 of the first hole 100Ha. In addition, a distance L2 from a third side d3 of the first area A1 to a third side e3 of the first hole 100Ha may be the same as a distance L2 from the fourth side d4 of the first area A1 to the fourth side e4 of the first hole 100Ha. Through this, during the encapsulation process, voids that occur most frequently in an area corresponding to a central area on the lower surface of the first semiconductor chip 110 may be more easily discharged in an area where the mold film is formed between the lower surface of the first semiconductor chip 110 and the upper surface of the first package substrate 100.

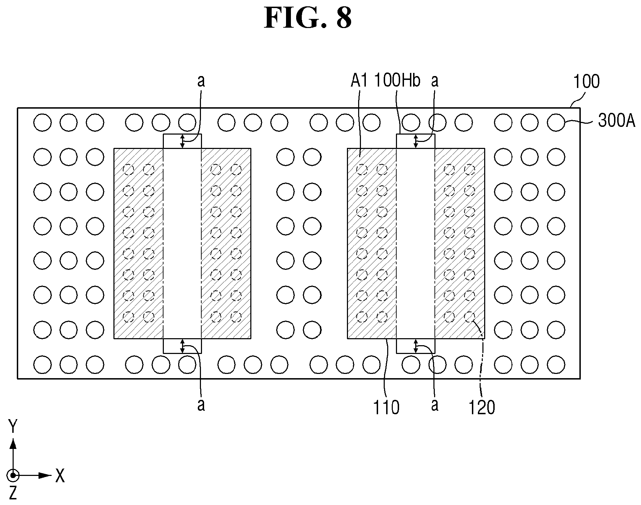

Referring to FIG. 8, in a semiconductor package according to an example embodiment, a length of the first hole 100Hb in the third direction Y may be formed to be longer than a length of the first semiconductor chip 110 in the third direction Y. For example, as illustrated in FIG. 8, each length of the first hole 100Hb on both sides in the third direction Y may be formed to be longer by 'a' than that of the first area A1 where the first semiconductor chip 110 is mounted on the first package substrate 100 by. Through this, during the encapsulation process, the voids inside the mold film formed between the lower surface of the first semiconductor chip 110 and the upper surface of the first package substrate 100 may be more easily discharged.

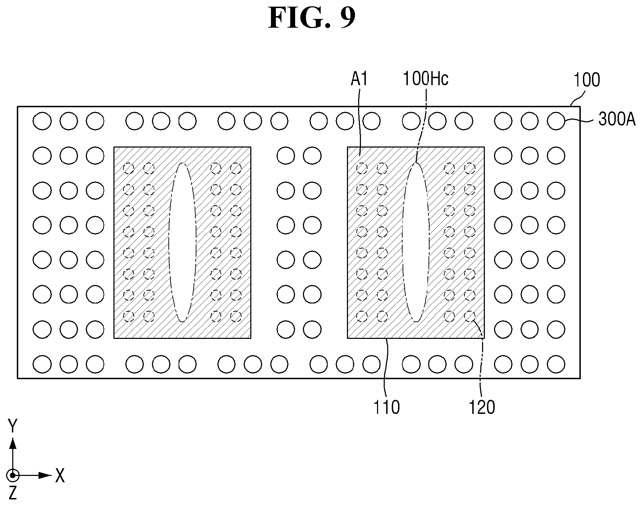

Referring to FIG. 9, in a semiconductor package according to an example embodiment, a first hole 100Hc may be formed in an elliptical shape extending to be long (e.g., elongating) in the third direction Y.

Various example embodiments of the first holes 100Ha, 100Hb, and 100Hc described with reference to FIGS. 7 to 9 may be equally applied to the second hole 200H formed in the second package substrate 200.

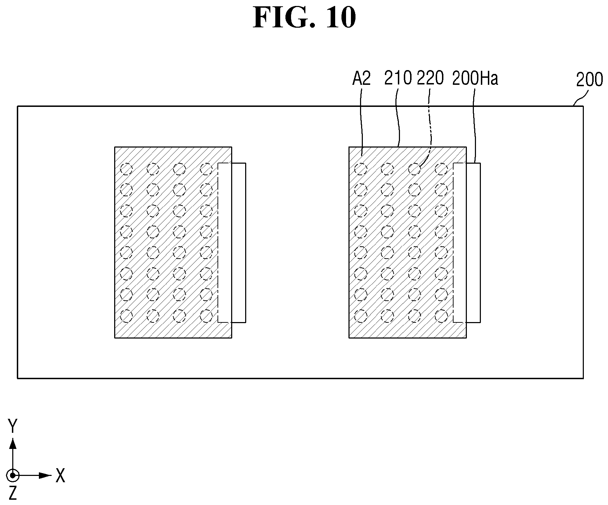

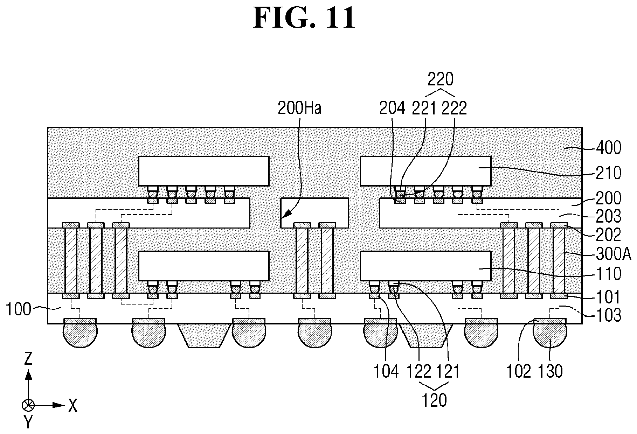

Next, referring to FIGS. 10 and 11, in a semiconductor package according to an example embodiment, a second hole 200Ha may be formed on the second package substrate 200 so that only a portion thereof overlaps the second area A2 in plan view, unlike that illustrated in FIG. 2.

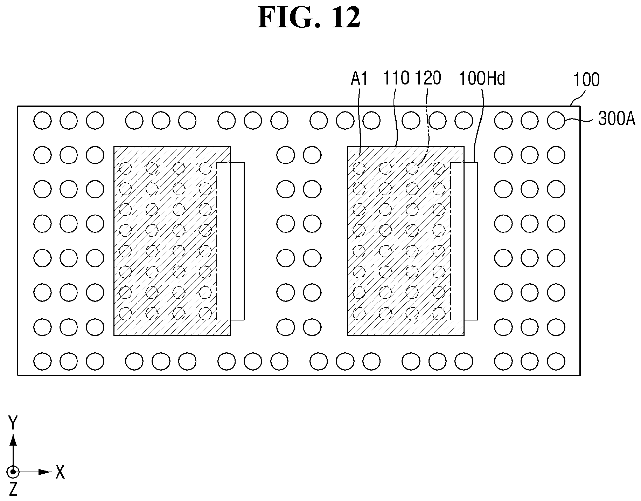

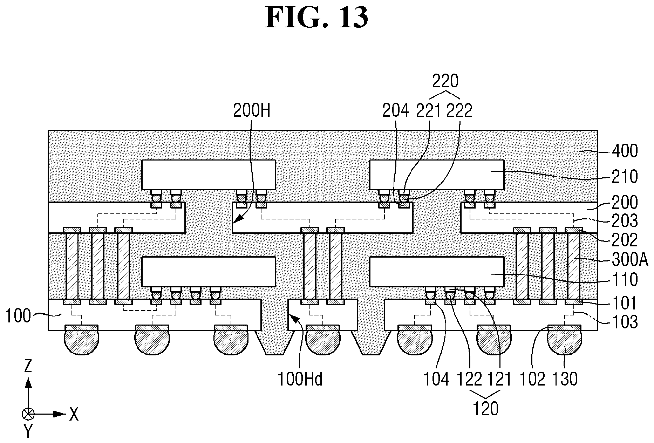

Next, referring to FIGS. 12 and 13, in a semiconductor package according to an example embodiment, a first hole 100Hd may be formed on the first package substrate 100 so that only a portion thereof overlaps the first area A1 in plan view, unlike that illustrated in FIG. 5.

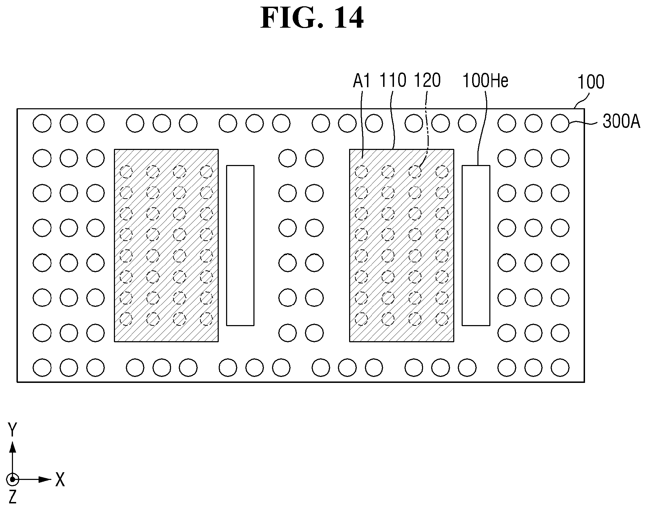

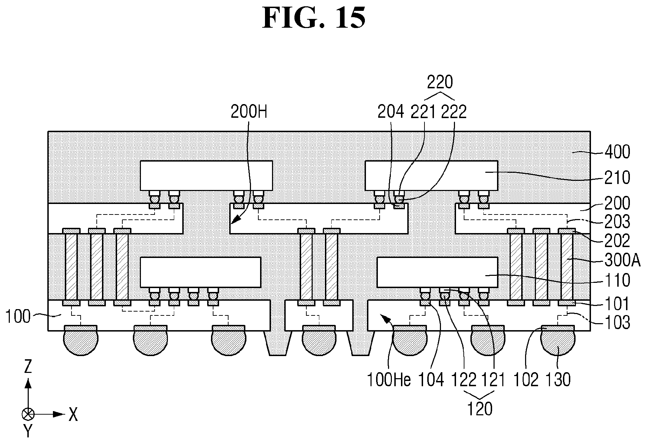

Next, referring to FIGS. 14 and 15, in a semiconductor package according to an example embodiment, a first hole 100He may be formed on the first package substrate 100 so as not to overlap the first area A1 in plan view, unlike those illustrated in FIG. 5 and FIGS. 12 and 13.

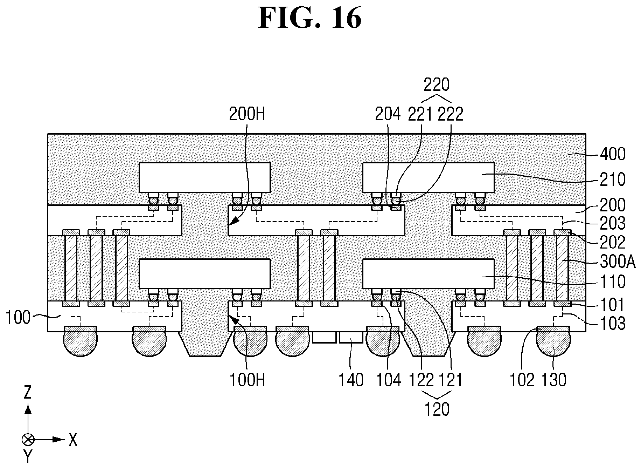

Referring to FIG. 16, in an example embodiment, a circuit element 140 may be disposed on the first package substrate 100. Although the circuit element 140 is illustrated as being disposed on the lower surface of the first package substrate 100, this is merely an example. The circuit element 140 may include, for example, various active elements such as transistors or various passive elements such as capacitors, resistors, and inductors. As an example, circuit element 140 may be a capacitor.

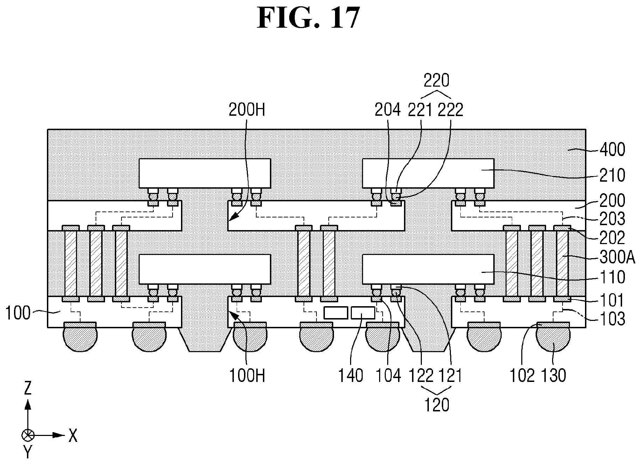

Referring to FIG. 17, in a semiconductor package according to an example embodiment, the circuit element 140 may be disposed in the first package substrate 100.

For example, the circuit element 140 may be disposed in an area between the first lower pad 102 and the upper pad 101 and/or in an area between the first lower pad 102 and the first chip pad 104.

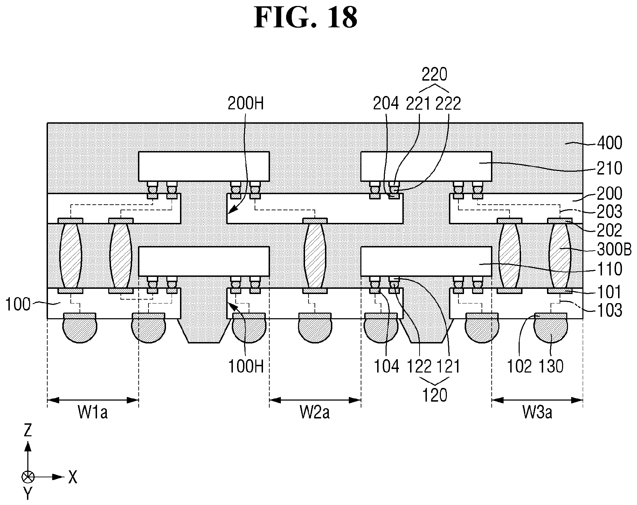

Next, referring to FIG. 18, in a semiconductor package according to an example embodiment, a connection member 300B may be implemented in a solder ball shape, unlike that illustrated in FIG. 5. In this case, when the connection members 300A (illustrated in FIG. 5) are implemented in a cylindrical post shape, lengths W1a, W2a, and W3a of areas where the connection members 300B are disposed in the second direction X may be longer than lengths W1, W2, and W3 (illustrated in FIG. 5) of the areas where the respective corresponding connection members 300A (illustrated in FIG. 5) are disposed in the second direction X, respectively. Therefore, in the semiconductor package, when a fine pitch is desired, the connection members 300A may be implemented in a cylindrical post shape as illustrated in FIG. 5.

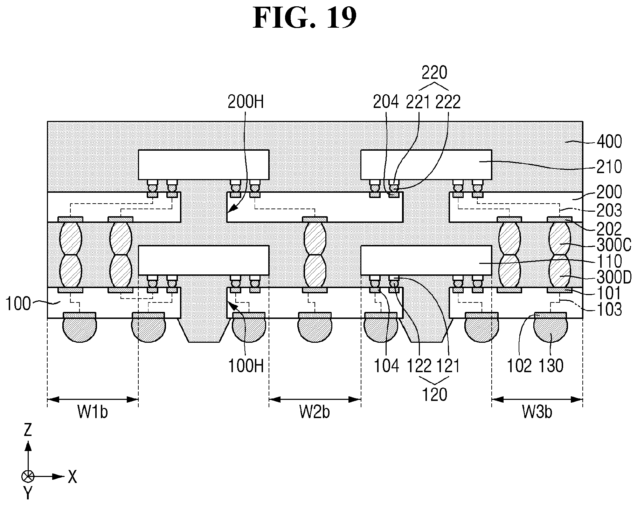

Next, referring to FIG. 19, in a semiconductor package according to an example embodiment, connection members 300C and 300D may be implemented in a form in which a solder ball-shaped connection member 300D and a solder ball-shaped connection member 300C are stacked and connected. In this case, when the connection member 300B (illustrated in FIG. 18) is implemented in the form of one solder ball, lengths W1b, W2b, and W3b of areas where the connection members 300C and 300D are disposed in the second direction X may be longer than lengths W1a, W2a, and W3a (illustrated in FIG. 18) of the areas where the respective corresponding connection members 300B (illustrated in FIG. 18) are disposed in the second direction X, respectively.

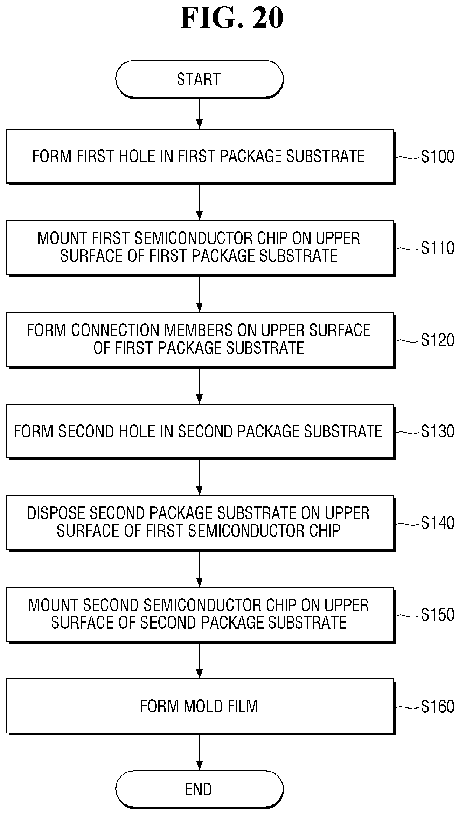

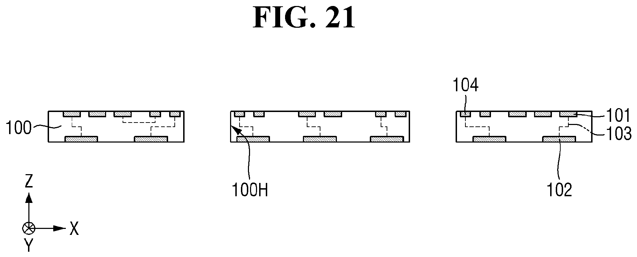

FIG. 20 is an illustrative flowchart illustrating a method of fabricating a semiconductor package according to an example embodiment. FIGS. 21 to 27 are intermediate step drawings for describing the method of fabricating the semiconductor package according to an example embodiment. Hereinafter, a method of fabricating a semiconductor package according to an example embodiment will be described with reference to FIGS. 20 to 27.

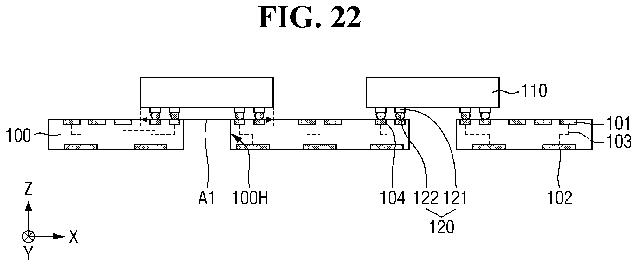

First, referring to FIGS. 20 and 21, a first hole 100H is formed on a first package substrate 100 (S100). The first hole 100H may be formed to penetrate through the first package substrate 100 in the first direction Z. In addition, the first hole 100H may be formed in a first area A1 (illustrated in FIG. 22), which is an area on which a first semiconductor chip 110 is mounted in the next process, on an upper surface of the first package substrate 100.

Next, referring to FIGS. 20 and 22, the first semiconductor chip 110 is mounted on the upper surface of the first package substrate 100 (S110). The first semiconductor chip 110 may be mounted on the first package substrate 100 so that a first solder layer 122 of a first chip bump group 120 formed on a lower surface of the first semiconductor chip 110 is in contact with a first chip pad 104 exposed from the upper surface of the first package substrate 100. The first semiconductor chip 110 may be mounted on the upper surface of the first package substrate 100 to overlap the first hole 100H in plan view.

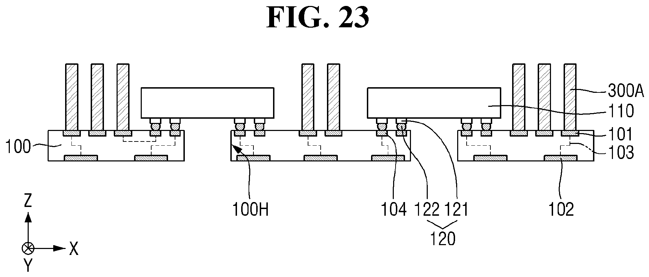

Next, referring to FIGS. 20 and 23, connection members 300A are formed on the upper surface of the first package substrate 100 (S120). In some example embodiments, the connection member 300A may be disposed so that a lower end thereof is in direct contact with the upper pad 101 exposed from the upper surface of the first package substrate 100.

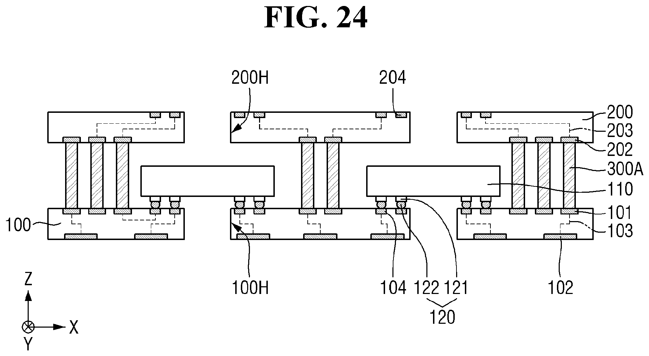

Next, referring to FIGS. 20 and 24, a second hole 200H is formed in a second package substrate 200 (S130), and the second package substrate 200 is disposed on the upper surface of the first semiconductor chip 110 (S140). In this case, the second package substrate 200 may be disposed on the upper surface of the first semiconductor chip 110 so that an upper end of the connection member 300A is in direct contact with a second lower pad 202 exposed from a lower surface of the second package substrate 200. Thus, the connection member 300A may directly and electrically connect the first package substrate 100 and the second package substrate 200 to each other.

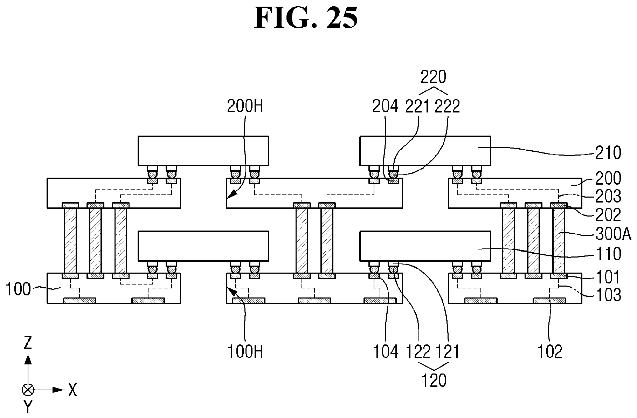

Next, referring to FIGS. 20 and 25, a second semiconductor chip 210 is mounted on an upper surface of the second package substrate 200 (S150). The second semiconductor chip 210 may be mounted on the second package substrate 200 so that a second solder layer 222 of a second chip bump group 220 formed on a lower surface of the second semiconductor chip 210 is in contact with a second chip pad 204 exposed from the upper surface of the second package substrate 200. The second semiconductor chip 210 may be mounted on the upper surface of the second package substrate 200 to overlap the second hole 200H in plan view.

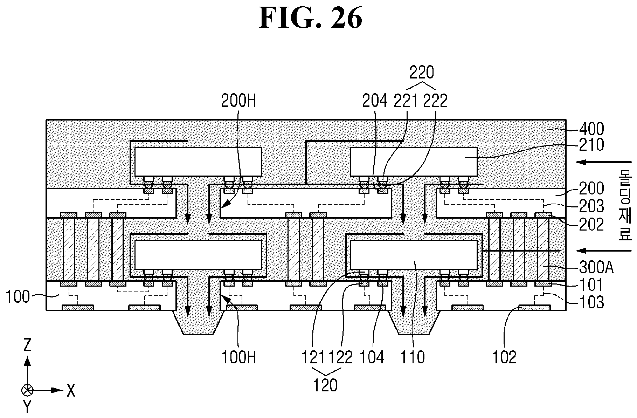

Next, referring to FIGS. 20 and 26, a mold film 400 is formed on the upper surfaces of the first package substrate 100 and the second package substrate 200 (S160). It is only illustrated in FIG. 26 that an encapsulation process is performed by a transfer molding method among molding methods, but example embodiments are not limited thereto. For example, in some example embodiments, the encapsulation process may be performed by a compression molding method. Hereinafter, a case in which the mold film 400 is formed by the transfer molding method will be described as an example. In addition, it is only illustrated in FIG. 26 that a molding material is introduced into the semiconductor package from one side in the second direction X, but example embodiments are not limited thereto. For example, the molding material may be introduced into the semiconductor package from an arbitrary direction on an X-Y plane.

The molding material introduced into the semiconductor package may pass through the second hole 200H and flow to the upper surfaces of the first semiconductor chip 110 and the first package substrate 100. Accordingly, the integrally formed mold film 400 may cover the first package substrate 100, the first semiconductor chip 110, and the connection member 300A, and may cover the second package substrate 200 and the second semiconductor chip 210 at the same time. In addition, the mold film 400 may fill a space between the lower surface of the first semiconductor chip 110 and the upper surface of the first package substrate 100, cover the first chip bump group 120, fill a space between the lower surface of the second semiconductor chip 210 and the upper surface of the second package substrate 200, and cover the second chip bump group 220. In addition, the mold film 400 may be formed to fill both first hole 100H and the second hole 200H.

As described above, because voids formed in the mold film 400 are easily discharged through the first hole 100H formed in the first package substrate 100 and the second hole 200H formed in the second package substrate 200, product reliability of the semiconductor package may be improved.

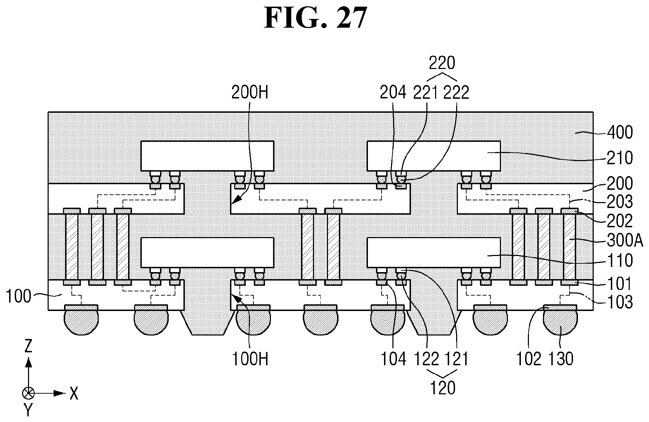

Next, referring to FIG. 27, a connection terminal 130 is attached to the first lower pad 102 of the first package substrate 100.

Some example embodiments of the present disclosure have been described above with reference to the accompanying drawings, but the present disclosure is not limited thereto and may be implemented in various different forms within the scope of the appended claims.

## Claims

1. A semiconductor package comprising:
a first package substrate (100) including a first area;
a first semiconductor chip (110) on the first area;
a second package substrate (200) on an upper surface of the first semiconductor chip (110), the second package substrate (200) including a second area and a first hole (200H) penetrating through the second area;
a second semiconductor chip (210) on the second area;
a connection member (300A) electrically connecting the first package substrate (100) and the second package substrate (200), the connection member (300A) being between the first package substrate (100) and the second package substrate (200);
a mold film (400) covering the second semiconductor chip (210) on the second package substrate (200), filling the first hole (200H), and covering the first semiconductor chip (110) and the connection member (300A) on the first package substrate (100), and
a second hole (100H) penetrating through the first package substrate (100), and
a first chip bump group (120) formed between the first semiconductor chip (110) and the first package substrate (100) and connecting the first semiconductor chip (110) and the first package substrate (100).

2. The semiconductor package of claim 1, wherein the second hole (200H) penetrates through the first area.

3. The semiconductor package of claim 1, wherein the second area overlaps the second semiconductor chip (210) on an upper surface of the second package substrate (200) in a vertical view.

4. The semiconductor package of claim 3, wherein the first hole (200H) is at a central part of the second area of the second package substrate (200).

5. The semiconductor package of claim 1, further comprising:
a second chip bump group (220) between the second semiconductor chip (210) and the second package substrate (200).

6. The semiconductor package of claim 5, wherein the second chip bump group (220) includes a first side chip bump on a first side of the first hole (200H) and a second side chip bump on a second side of the first hole (200H).

7. A semiconductor package according to claim 1, further comprising:
an upper pad (101) exposed from an upper surface of the first package substrate (100); and
a lower pad (102) exposed from a lower surface of the second package substrate (200), wherein:
the first semiconductor chip (110) is on the upper surface of the first package substrate (100),
the second package substrate (200) is on an upper surface of the first semiconductor chip (110) and spaced apart from the upper surface of the first semiconductor chip (110),
the second semiconductor chip (210) is on an upper surface of the second package substrate (200),
the connection member (300A) is in direct contact with the upper pad (101) and the lower pad (102),
the first package substrate (100) includes a second hole (100H) penetrating through the first package substrate (100) in a first direction,
the first hole (200H) penetrates through the second package substrate (200) in the first direction,
the second hole (100H) overlaps the first semiconductor chip (110) in plan view, and
the first hole (200H) overlaps the second semiconductor chip (210) in plan view.

8. The semiconductor package of claim 7, wherein the mold film (400) fills both the second hole (100H) and the first hole (200H).

9. The semiconductor package of claim 1, wherein the mold film (400) fills a space between the lower surface of the first semiconductor chip (110) and the upper surface of the first package substrate (100) and covers the first chip bump group (120).

10. A method of fabricating a semiconductor package, the method comprising:
forming a first hole penetrating through a first package substrate in a first direction (S100);
providing a first semiconductor chip;
forming a first chip bump group (120) on an upper surface of the first package substrate and between the first semiconductor chip (110) and the first package substrate (100);
mounting the first semiconductor chip via the first chip bump group (120) on the upper surface of the first package substrate so as to overlap the first hole in plan view (S110);
forming a connection member on the upper surface of the first package substrate (S120);
forming a second hole penetrating through a second package substrate in the first direction (S130);
disposing the second package substrate on an upper surface of the first semiconductor chip so that an upper end of the connection member is in direct contact with a lower pad exposed from a lower surface of the second package substrate (S140);
mounting a second semiconductor chip on an upper surface of the second package substrate so as to overlap the second hole in plan view (S150); and
forming a mold film (S160) covering the first semiconductor chip and the connection member on the first package substrate and covering the second semiconductor chip on the second package substrate.

11. The method of claim 10, wherein
the first package substrate includes an upper pad exposed from the upper surface of the first package substrate,
a lower end of the connection member is in direct contact with the upper pad, and
the connection member electrically connects the first package substrate and the second package substrate.

12. The method of claim 10, wherein the mold film is formed to cover between a lower surface of the first semiconductor chip and the upper surface of the first package substrate.

## Patentansprüche

1. Halbleiter-Package, aufweisend:
ein erstes Package-Substrat (100) mit einem ersten Bereich;
einen ersten Halbleiterchip (110) auf dem ersten Bereich;
ein zweites Package-Substrat (200) auf einer oberen Oberfläche des ersten Halbleiterchips (110), wobei das zweite Package-Substrat (200) einen zweiten Bereich und ein erstes Loch (200H), das durch den zweiten Bereich hindurch verläuft, beinhaltet;
einen zweiten Halbleiterchip (210) auf dem zweiten Bereich;
ein Verbindungselement (300A), das das erste Package-Substrat (100) und das zweite Package-Substrat (200) elektrisch verbindet, wobei sich das Verbindungselement (300A) zwischen dem ersten Package-Substrat (100) und dem zweiten Package-Substrat (200) befindet;
eine Vergussmasse-Schicht (400), die den zweiten Halbleiterchip (210) auf dem zweiten Package-Substrat (200) abdeckt, das erste Loch (200H) füllt, und den ersten Halbleiterchip (110) und das Verbindungselement (300A) auf dem ersten Package-Substrat (100) abdeckt, und
ein zweites Loch (100H), das durch das erste Package-Substrat (100) hindurch verläuft, und
eine erste Chip-Bump-Gruppe (120), die zwischen dem ersten Halbleiterchip (110) und dem ersten Package-Substrat (100) gebildet ist und den ersten Halbleiterchip (110) und das erste Package-Substrat (100) verbindet.

2. Halbleiter-Package nach Anspruch 1, wobei das zweite Loch (200H) durch den ersten Bereich hindurch verläuft.

3. Halbleiter-Package nach Anspruch 1, wobei der zweite Bereich sich mit dem zweiten Halbleiterchip (210) auf einer oberen Oberfläche des zweiten Package-Substrats (200) in einer vertikalen Ansicht überlappt.

4. Halbleiter-Package nach Anspruch 3, wobei das erste Loch (200H) sich an einem mittigen Teil des zweiten Bereichs des zweiten Package-Substrats (200) befindet.

5. Halbleiter-Package nach Anspruch 1, ferner aufweisend:
eine zweite Chip-Bump-Gruppe (220) zwischen dem zweiten Halbleiterchip (210) und dem zweiten Package-Substrat (200).

6. Halbleiter-Package nach Anspruch 5, wobei die zweite Chip-Bump-Gruppe (220) einen ersten Seiten-Chip-Bump auf einer ersten Seite des ersten Lochs (200H) und einen zweiten Seiten-Chip-Bump auf einer zweiten Seite des ersten Lochs (200H) beinhaltet.

7. Halbleiter-Package nach Anspruch 1, ferner aufweisend:
ein oberes Pad (101), das von einer oberen Oberfläche des ersten Package-Substrats (100) freiliegt; und
ein unteres Pad (102), das von einer unteren Oberfläche des zweiten Package-Substrats (200) freiliegt, wobei:
der erste Halbleiterchip (110) sich auf der oberen Oberfläche des ersten Package-Substrats (100) befindet,
das zweite Package-Substrat (200) sich auf einer oberen Oberfläche des ersten Halbleiterchips (110) befindet und von der oberen Oberfläche des ersten Halbleiterchips (110) beabstandet ist,
der zweite Halbleiterchip (210) sich auf einer oberen Oberfläche des zweiten Package-Substrats (200) befindet,
das Verbindungselement (300A) mit dem oberen Pad (101) und dem unteren Pad (102) in direktem Kontakt steht,
das erste Package-Substrat (100) ein zweites Loch (100H) beinhaltet, das durch das erste Package-Substrat (100) in einer ersten Richtung hindurch verläuft,
das erste Loch (200H) durch das zweite Package-Substrat (200) in der ersten Richtung hindurch verläuft,
das zweite Loch (100H) den ersten Halbleiterchip (110) in einer Draufsicht überlappt, und
das erste Loch (200H) den zweiten Halbleiterchip (210) in einer Draufsicht überlappt.

8. Halbleiter-Package nach Anspruch 7, wobei die Vergussmasse-Schicht (400) sowohl das zweite Loch (100H), als auch das erste Loch (200H) füllt.

9. Halbleiter-Package nach Anspruch 1, wobei die Vergussmasse-Schicht (400) einen Raum zwischen der unteren Oberfläche des ersten Halbleiterchips (110) und der oberen Oberfläche des ersten Package-Substrats (100) füllt und die erste Chip-Bump-Gruppe (120) abdeckt.

10. Verfahren zum Herstellen eines Halbleiter-Packages, wobei das Verfahren aufweist:
Bilden eines ersten Lochs, das in einer ersten Richtung durch ein erstes Package-Substrat hindurch verläuft (S100);
Bereitstellen eines ersten Halbleiterchips;
Bilden einer ersten Chip-Bump-Gruppe (120) auf einer oberen Oberfläche des ersten Package-Substrats und zwischen dem ersten Halbleiterchip (110) und dem ersten Package-Substrat (100);
Befestigen des ersten Halbleiterchips auf der oberen Oberfläche des ersten Package-Substrats über die erste Chip-Bump-Gruppe (120), so dass er sich in einer Draufsicht mit dem ersten Loch überlappt (S110);
Bilden eines Verbindungselements auf der oberen Oberfläche des ersten Package-Substrats (S120);
Bilden eines zweiten Lochs, das in der ersten Richtung durch ein zweites Package-Substrat hindurch verläuft (S130);
Anordnen des zweiten Package-Substrats auf einer oberen Oberfläche des ersten Halbleiterchips, so dass ein oberes Ende des Verbindungselements in direktem Kontakt mit einem unteren Pad steht, das von einer unteren Oberfläche des zweiten Package-Substrats freiliegt (S140);
Befestigen eines zweiten Halbleiterchips auf einer oberen Oberfläche des zweiten Package-Substrats, so dass es sich in einer Draufsicht mit dem zweiten Loch überlappt (S150); und
Bilden einer Vergussmasse-Schicht (S160), die den ersten Halbleiterchip und das Verbindungselement auf dem ersten Package-Substrat abdeckt und den zweiten Halbleiterchip auf dem zweiten Package-Substrat abdeckt.

11. Verfahren nach Anspruch 10, wobei
das erste Package-Substrat ein oberes Pad beinhaltet, das von der oberen Oberfläche des ersten Package-Substrats freiliegt,
ein unteres Ende des Verbindungselements in direktem Kontakt mit dem oberen Pad steht, und
das Verbindungselement das erste Package-Substrat und das zweite Package-Substrat elektrisch verbindet.

12. Verfahren nach Anspruch 10, wobei die Vergussmasse-Schicht gebildet wird, um eine Abdeckung zwischen einer unteren Oberfläche des ersten Halbleiterchips und der oberen Oberfläche des ersten Package-Substrats herzustellen.

## Revendications

1. Ensemble semi-conducteur comprenant :
un premier substrat (100) comprenant une première zone ;
une première puce semi-conductrice (110) sur la première zone ;
un deuxième substrat (200) sur une surface supérieure de la première puce semi-conductrice (110), le deuxième substrat (200) comprenant une deuxième zone et un premier trou (200H) traversant la deuxième zone ;
une deuxième puce semi-conductrice (210) sur la deuxième zone ;
un élément de connexion (300A) reliant électriquement le premier substrat (100) et le deuxième substrat (200), l'élément de connexion (300A) étant disposé entre le premier substrat (100) et le deuxième substrat (200) ;
un film de moulage (400) recouvrant la deuxième puce semi-conductrice (210) sur le deuxième substrat (200), remplissant le premier trou (200H), et recouvrant la première puce semi-conductrice (110) ainsi que l'élément de connexion (300A) sur le premier substrat (100) ; et
un deuxième trou (100H) traversant le premier substrat (100) ;
un premier groupe de plots de puce (120) formé entre la première puce semi-conductrice (110) et le premier substrat (100), et reliant la première puce semi-conductrice (110) au premier substrat (100).

2. Ensemble semi-conducteur selon la revendication 1, dans lequel le deuxième trou (200H) traverse la première zone.

3. Ensemble semi-conducteur selon la revendication 1, dans lequel la deuxième zone chevauche la deuxième puce semi-conductrice (210) sur une surface supérieure du deuxième substrat (200), en vue verticale.

4. Ensemble semi-conducteur selon la revendication 3, dans lequel le premier trou (200H) se situe dans une partie centrale de la deuxième zone du deuxième substrat (200).

5. Ensemble semi-conducteur selon la revendication 1, comprenant en outre :
un deuxième groupe de plots de puce (220) entre la deuxième puce semi-conductrice (210) et le deuxième substrat (200).

6. Ensemble semi-conducteur selon la revendication 5, dans lequel le deuxième groupe de plots de puce (220) comprend un plot de puce latéral situé sur un premier côté du premier trou (200H) et un plot de puce latéral situé sur un deuxième côté du premier trou (200H).

7. Ensemble semi-conducteur selon la revendication 1, comprenant en outre :
une pastille supérieure (101) exposée depuis une surface supérieure du premier substrat (100) ; et
une pastille inférieure (102) exposée depuis une surface inférieure du deuxième substrat (200),
dans lequel :
la première puce semi-conductrice (110) est sur la surface supérieure du premier substrat (100),
le deuxième substrat (200) est situé sur une surface supérieure de la première puce semi-conductrice (110) et est espacé de la première puce semi-conductrice (110),
la deuxième puce semi-conductrice (210) est sur une surface supérieure du deuxième substrat (200),
l'élément de connexion (300A) est en contact direct avec la pastille supérieure (101) et la pastille inférieure (102),
le premier substrat (100) comprend un deuxième trou (100H) traversant le premier substrat (100) selon une première direction,
le premier trou (200H) traverse le deuxième substrat (200) selon ladite première direction,
le deuxième trou (100H) chevauche la première puce semi-conductrice (110) en vue de dessus, et
le premier trou (200H) chevauche la deuxième puce semi-conductrice (210) en vue de dessus.

8. Ensemble semi-conducteur selon la revendication 7, dans lequel le film de moulage (400) remplit à la fois le deuxième trou (100H) et le premier trou (200H).

9. Ensemble semi-conducteur selon la revendication 1, dans lequel le film de moulage (400) remplit un espace entre la surface inférieure de la première puce semi-conductrice (110) et la surface supérieure du premier substrat (100), et recouvre le premier groupe de plots de puce (120).

10. Procédé de fabrication d'un ensemble semi-conducteur, le procédé comprenant les étapes suivantes:
former un premier trou traversant un premier substrat selon une première direction (S100) ;
fournir une première puce semi-conductrice ;
former un premier groupe de plots de puce (120) sur une surface supérieure du premier substrat et entre la première puce semi-conductrice (110) et le premier substrat (100) ;
monter la première puce semi-conductrice par l'intermédiaire du premier groupe de plots de puce (120) sur la surface supérieure du premier substrat de manière à chevaucher le premier trou en vue de dessus (S110) ;
former un élément de connexion sur la surface supérieure du premier substrat (S120) ;
former un deuxième trou traversant un deuxième substrat selon la première direction (S130) ;
disposer le deuxième substrat sur une surface supérieure de la première puce semi-conductrice de sorte qu'une extrémité supérieure de l'élément de connexion soit en contact direct avec une pastille inférieure exposée depuis une surface inférieure du deuxième substrat (S140) ;
monter une deuxième puce semi-conductrice sur une surface supérieure du deuxième substrat de sorte qu'elle chevauche le deuxième trou en vue de dessus (S150) ; et
former un film de moulage (S160) recouvrant la première puce semi-conductrice et l'élément de connexion sur le premier substrat, et recouvrant la deuxième puce semi-conductrice sur le deuxième substrat.

11. Procédé selon la revendication 10, dans lequel :
le premier substrat comprend une pastille supérieure exposée depuis la surface supérieure du premier substrat,
une extrémité inférieure de l'élément de connexion est en contact direct avec la pastille supérieure, et
l'élément de connexion relie électriquement le premier substrat et le deuxième substrat.

12. Procédé selon la revendication 10, dans lequel le film de moulage est formé de manière à couvrir un espace entre une surface inférieure de la première puce semi-conductrice et une surface supérieure du premier substrat.
